# EUROPEAN PATENT APPLICATION

(11) **EP 4 692 539 A1**
(43) Date of publication of application: **11.02.2026**
(21) Application number: 25193961.7
(22) Date of filing: 05.08.2025
(51) Int. Cl.: F04B 19/00, F04B 43/04, B01L 3/00

(54) **INTEGRATED MODULAR MULTI-TONE PIEZOELECTRIC ELEMENT DRIVER AND METHOD OF DRIVING MODULAR MULTI-TONE PIEZOELECTRIC ELEMENT DRIVER FOR PRESSURE GENERATION**

(30) Priority: 08.08.2024 EE 202400014
(71) Applicant: Tallinna Tehnikaülikool, 19086 Tallinn (EE)
(72) Inventor: Jõemaa, Rauno, 19086 Tallinn (EE); Pardy, Tamás, Tallinn, 19086 (EE)
(74) Representative: Moosedog Oy

(57) **Abstract**

Disclosed is an integrated modular multi-tone piezoelectric element driver for pressure generation comprising a first layer and a second layer. The first layer comprises analog oscillators, a first voltage-controlled amplifier, a first lever shifter and a summer to generate a multi-tone waveform. The second layer comprises a second voltage-controlled amplifier, a second level shifter, one or more operational amplifiers, a third level shifter, a fourth level shifter, one or more high impedance amplifiers and a high impedance amplifier to generate four amplified signals for controlling a pressure.

## Description

### TECHNICAL FIELD

The present disclosure relates to an integrated modular multi-tone piezoelectric element driver and a method of using the driver for pressure generation.

### BACKGROUND

Microfluidics is a field of research, which handles liquids at scales where one of the flow path cross-sectional dimensions is shorter than a millimeter. A peculiar fluid dynamic is reached when the flowing liquid volume and mass become small enough that forces independent of mass such as viscosity, surface tension and channel wettability become the dominant forces in flow behavior. Thus, when inertial forces have been made insignificant in comparison, liquid can be made to flow in a predictable, layered form, without turbulence - a phenomenon referred to as laminar flow, where flow lines do not break. The most notable advantage gained from this, besides higher process accuracy and resolution, are lower reagent cost in experiments and an increase to the rate of testing, which in turn drives to design tools and methods to managing and thereby requiring smaller and smaller sample sizes.

For such systems, piezoelectric micropumps are used as pressure regulators. Interest in piezoelectric actuators has been growing in microfluidics due to their small size and weight, power efficiency, low-cost and responsiveness. In a piezoelectric micropump, applying a changing voltage difference across the opposing faces of a thin disc of piezoelectric material, acting as the diaphragm, deforms and alternates the deformation direction of the disc. Piezoelectric element drivers are used to drive these micropumps. Typical drivers come minimally with frequency and amplitude control capabilities, allowing users to access the full output pressure range of their pumps. Some drivers also provide limited control over the waveform shape among options like sinusoidal, trapezoidal, and square wave. It is common for the waveforms to be generated digitally, formed of voltage steps following an equation or a precalculated lookup table stored in memory.

In piezoelectric pumps the resulting pressure also carries the oscillatory motion of the diaphragm into the connected fluidics as pressure pulsations. In applications involving droplet generation, pulsatile flow can be detrimental to the size stability of droplets produced. Moreover, when droplet generation rates are ramped up, the increasing pressure levels, mainly facilitated by increasing the deformation severity of the pump's diaphragm, subsequently increase the amplitude of the following pressure pulsations.

Therefore, the above-described systems do not produce adequately stable pressures with piezoelectric micropumps, so that for example the droplet generation would be stable. The coefficient of variability observed for such systems is not suitable for many applications. Further, there's a lack of broader use drivers with features including on-board high-voltage waveform generation, analog amplitude control, compatibility with asymmetrically polarized multi chamber pumps and a broad frequency range for various media.

Therefore, in light of the foregoing discussion, there exists a need to overcome the aforementioned drawbacks associated with providing pressure generation and control for the piezoelectric pumps.

### SUMMARY

The aim of the present disclosure is to provide an integrated modular multi-tone piezoelectric element driver for pressure generation that allows stable and accurate pressure control for the piezoelectric pumps. Advantageous features are set out in the appended dependent claims.

Throughout the description and claims of this specification, the words "*comprise*", "*include*", "*have*", and "*contain*" and variations of these words, for example "*comprising*" and "*comprises*", mean "*including but not limited to*", and do not exclude other components, items, integers or steps not explicitly disclosed also to be present. Moreover, the singular encompasses the plural unless the context otherwise requires. In particular, where the indefinite article is used, the specification is to be understood as contemplating plurality as well as singularity, unless the context requires otherwise.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific instrumentalities disclosed herein. Moreover, those skilled in the art will understand that the drawings are not to scale. Wherever possible, similar elements have been indicated by identical numbers.
FIG. 1A and FIG. 1B are schematic illustrations of the first layer, in accordance with an embodiment of the present disclosure.
FIG. 2A and FIG. 2B are schematic illustrations of the second layer, in accordance with an embodiment of the present disclosure.
FIG. 3A and FIG. 3B are schematic illustrations of the third layer, in accordance with an embodiment of the present disclosure.
FIG.4 is a graph illustrating a generated pressure with integrated modular multi-tone piezoelectric element driver, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

In a first aspect, the present disclosure provides an integrated modular multi-tone piezoelectric element driver for pressure generation, comprising:
a first layer (L1) comprising:
   - a primary analog oscillator configured to generate a major waveform (WF1),
   - a secondary analog oscillator configured to generate a minor waveform (WF2),
   - a first voltage-controlled amplifier configured to adjust the amplitude of the minor waveform (WF2) to obtain an adjusted minor waveform (WF2*),
   - a first level shifter configured to correct a direct current component of the adjusted minor waveform (WF2*),
   - a summer configured to sum the major waveform (WF1) and the adjusted minor waveform (WF2*) to create a multi-tone waveform (WF1+WF2*),
a second layer (L2) comprising:
   - a second voltage-controlled amplifier configured to adjust an amplitude of the multi-tone waveform (WFx) to obtain an adjusted multi-tone waveform (WFx*),
   - a second level shifter configured to correct the direct current component of the adjusted multi-tone waveform (WFx*),
   - one or more operational amplifiers configured to attenuate and subsequently invert the adjusted multi-tone waveform (WFx*) to create an attenuated and inverted adjusted multi-tone waveform (WFxA) and to invert the attenuated and inverted adjusted multi-tone waveform (WFxA) to create an inverted waveform (-WFxA),
   - a third level shifter and a fourth level shifter configured to adjust the direct current level of the attenuated and inverted adjusted multi-tone waveform (WFxA) and the inverted waveform (-WFxA), resulting in a first signal (WF_C) and a second signal (WF_B), respectively,
   - one or more high impedance amplifiers configured to amplify the first signal (WF_C) into a third signal (WF_A) and the second signal (WF_B) into a fourth signal (WF_D), respectively,
   - a quad high impedance amplifier configured to amplify the third signal (WF_A), the first signal (WF_C), the second signal (WF_B) and the fourth signal (WF_D) to respectively produce an amplified third signal (P1+), an amplified first signal (P2-), an amplified second signal (P1-) and an amplified fourth signal (P2+), wherein the amplified third signal (P1+), the amplified first signal (P2-), the amplified second signal (P1-) and the amplified fourth signal (P2+) are used for controlling a pressure.

In a second aspect, the present disclosure provides a method of driving a modular multi-tone piezoelectric element driver for pressure generation, the method comprising:
- generating a major waveform (WF1) with a primary analogue oscillator;
- generating a minor waveform (WF2) with a secondary analogue oscillator;
- adjusting an amplitude of the minor waveform with a first voltage-controlled amplifier to obtain an adjusted minor waveform (WF2*);
- correcting a direct current component of the adjusted minor waveform (WF2*);
- summing the major waveform and the adjusted minor waveform to create a multi-tone waveform (WF1+WF2*);
- adjusting an amplitude of the multi-tone waveform (WF1+WF2*) to form an adjusted multi-tone waveform (WFx*);
- correcting the direct current component of the adjusted multi-tone waveform (WFx*);
- attenuating and subsequently inverting the adjusted multi-tone waveform (WFx*) to create an attenuated and inverted adjusted multi-tone waveform (WFxA) and inverting the attenuated and inverted adjusted multi-tone waveform (WFxA) to create an inverted waveform (-WFxA);
- adjusting the direct current level of the attenuated and inverted adjusted multi-tone waveform (WFxA) and the inverted waveform (-WFxA), resulting in a first signal (WF_C) and a second signal (WF_B), respectively;
- amplifying the first signal (WF_C) into a third signal (WF_A) and the second signal (WF_B) into a fourth signal (WF_D), respectively;
- amplifying the third signal (WF_A), the first signal (WF_C), the second signal (WF_B) and the fourth signal (WF_D) to respectively produce an amplified third signal (P1+), an amplified first signal (P2-), an amplified fourth signal (P1-) and an amplified third signal (P2+), wherein the amplified third signal (P1+), the amplified first signal (P2-), the amplified second signal (P1-) and the amplified fourth signal (P2+) used for pressure control.

Herein, the term "the integrated modular multi-tone piezoelectric element driver" refers to a specialized electronic circuit that provides the necessary electrical signals to a piezoelectric element. The piezoelectric element is at the core of a piezoelectric pump, which is a material that can change shape or size when an electric voltage is applied. The piezoelectric element converts electrical energy into mechanical movement. The integrated modular multi-tone piezoelectric element driver controls voltage, frequency, and waveform applied to the piezoelectric element, which in turn controls the movement and operation of the piezoelectric pump. Optionally, the piezoelectric pump is a piezoelectric micropump. The integrated modular multi-tone piezoelectric element driver allows for precise control over the piezoelectric element, enabling accurate regulation of the piezoelectric pump's flow rate and pressure. By adjusting electrical signals, the performance of the piezoelectric pump can be finely tuned to meet specific requirements.

In regard to the first aspect of the present invention, the integrated modular multi-tone piezoelectric element driver for pressure control comprises the first layer and the second layer. Herein, the term "first layer" refers to driver layer which generates the multi-tone waveform. Herein, the term "second layer" refers to the driver layer where the multi-tone waveform phase and amplitude are adjusted. The term "waveform" refers to a graphical representation of the variation of an electrical signal's voltage (or current) over time, which is applied to the piezoelectric element to induce mechanical motion. The specific shape, frequency, amplitude, and phase of the waveform determine how the piezoelectric element deforms and thereby controls the performance of the piezoelectric pump. Herein, the term "multi-tone waveform" refers to a waveform composed of two distinct frequencies.

The first layer has the primary analog oscillator and the secondary analog oscillator. The primary oscillator and the secondary oscillator produce a sine wave with harmonic distortions < 2%. The primary analog oscillator offers individually adjustable frequency for the major waveform (10 - 2500 Hz) and the secondary analog oscillator for the minor waveform (100 - 25000 Hz). Optionally, the frequency for the major waveform may be from 10, 250, 500, 750, 1000, 1250, 1500, 1750, 2000, 2250 Hz up to 100, 300, 550, 800, 1050, 1300, 1550, 1800, 2250, 2500 Hz. Optionally, the frequency for the minor waveform may be from 100, 1000, 2500, 5000, 7500, 10000, 12500, 15000, 17500, 20000, 22500 Hz up to 250, 1250, 3000, 5500, 8000, 10500, 13000, 15500, 18000, 20500, 25000 Hz. The frequency control of the analog oscillators is highly linear and stable. The frequencies of the minor and the major waveform depend on the resistor and capacitor values in the oscillator's positive feedback loop and the values are independent from each other. Wide range of the frequencies that analog oscillators provide allow to control the pressure of various liquids with different properties such as viscosity.

When piezoelectric pumps are used in microfluidics, they are controlled by piezoelectric element drivers, to produce a pressure that moves the liquid. Piezoelectric pumps function on the principle of a diaphragm pump, with a rapid continuous push and pull actuation of a piezoelectric element. This motion produces inherent pulsations. These pulsations interfere with the stability of microflows that are required for uniform droplet generation. As the inherent pulsations, mainly caused by the major waveform of the piezoelectric element actuation, are required for the pump to operate, it is very difficult to get rid of them entirely. The term "major waveform" refers to a waveform that causes the function-required movement in a piezoelectric pump that produces the significant portion of the pressure. The term "minor waveform" refers to an additional waveform that is added to the major waveform to induce secondary pulsation in the pressure generated by a piezoelectric pump. The minor waveform causes proportionally less impactful movement in the piezoelectric pump compared to the major waveform, but it is the minor waveform that provides pulsations in pressure which can be controlled with less regard to its resonance with the pumped media. Instead, the minor waveform enables resonance to other components or particles in the piezoelectric pump or following pressurized system.

The advantage of the analog oscillators is that these exhibit lower phase noise than their digital counterparts. Low phase noise is crucial in applications such as pressure control for the piezoelectric micropumps. Further, the analog oscillators are capable of generating continuous, smooth waveforms (sine, square, triangle, etc.) without the quantization errors that can occur in digital systems and beneficially. Analog oscillators operate over a wide frequency range, making them versatile for controlling pressure in wide range. They can be easily tuned to different frequencies without needing complex reconfiguration. Analog waveforms, used to drive piezoelectric elements, often have purer energy transfer and thereby consume less power compared to digital, making them suitable for small devices such as microfluidic devices. Additionally, this leads to smoother operation and reduced wear on the pump components.

The first voltage-controlled amplifier is used to adjust an amplitude of the minor waveform. Only the amplitude of the minor waveform is attenuated to play a less significant role in the driver output. The first voltage-controlled amplifier is used to complement a theoretically infinite resolution of the minor waveform. Furthermore, when the driver is used to control a piezoelectric pump in a feedback loop, where the piezoelectric pump's output pressure needs to be stabilized, ideally at any value, the higher the available amplitude control the user has over the pressure-producing signal, the smaller the error between the desired and provided pressure, the smaller the feedback oscillations, the smaller the pseudo-pulsations in the pumping pressure.

The first level shifter is used to correct a direct current component of the adjusted minor waveform. This helps to maintain signal integrity, protect instruments where the integrated modular multi-tone piezoelectric element driver is used, ensure accurate signal processing, and achieving efficient and reliable operation of electronic systems. The term "*level shifter*" refers to a circuit method that replicates the input signal AC shape but raises or lowers the DC component. The first level shifter herein moves the DC component of the minor waveform so that the DC components of the major waveform and the adjusted minor waveform match before reaching the summer. Aligning the summing point in the summer to the matching DC components offers numerous advantages, including improved signal clarity, making it optional to have a unipolar supply, simplified signal analysis, reduced power consumption, and better interference handling.

The summer is used to sum the major waveform and the adjusted minor waveform to generate the multi-tone waveform. Beneficially, the multi-tone waveform provides more precise control over the piezoelectric elements. By using the major waveform and the minor waveform with different frequencies, the piezoelectric pump can achieve more refined control of fluid flow rates and pressures. While maintaining an optimal mechanical resonance between the piezoelectric element and the fluid, the minor waveform can be adjusted to resonate with another component or particle in the system. Different combinations of the minor waveform and the major waveform frequencies can be used to switch between various flow rates or pressure settings without needing complex mechanical adjustments.

In the second layer, takes the multi-tone waveform from the first layer and adjusts it and then splits into four signals which are used to control the pressure of the piezoelectric pump. The second voltage-controlled amplifier of the second layer adjusts the amplitude of the multi-tone waveform. The multi-tone waveform is attenuated to obtain the adjusted multi-tone waveform.

The second level shifter, configured to correct the direct current component of the adjusted multi-tone waveform. This is needed for maintaining symmetry in oscillations in order to avoid asymmetry when inverting the waveform which can result in inefficient operation, reduced performance, and increased wear and tear on mechanical components. Furthermore, it reduces the noise.

One or more operational amplifiers are further used to attenuate the amplitude of the adjusted multi-tone waveform. The attenuation is done at the fixed ratio in order to obtain a desired waveform. In case the integrated modular multi-tone piezoelectric element driver is used to drive the piezoelectric element whose manufacturing polarization is uneven, this attenuation step is used to configure a "negative" polarity level - later contrasted to a "positive" polarity level. After attenuation inversion is applied. Altogether, the adjusted multi-tone waveform is first attenuated and then inverted to create an attenuated and inverted adjusted multi-tone waveform. And then subsequently, the attenuated and inverted adjusted multi-tone waveform is inverted to create an inverted waveform. This assures that there are two waveforms, the attenuated and inverted adjusted multi-tone waveform and the inverted waveform, are now accurate and in the correct phase.

The third level shifter and the fourth level shifter, the attenuated and inverted adjusted multi-tone waveform and the inverted waveform are individually carried through the third level shifter and the fourth level shifter, to produce a first signal and the second signal, respectively. This is again needed for maintaining symmetry in oscillations as this asymmetry can result in inefficient operation, reduced performance, and increased wear and tear on mechanical components. Furthermore, it reduces the noise.

One or more high impedance amplifiers are used to amplify the first signal and the second signal into opposite polarity. Consequently, the first signal produces the third signal and the second signal produces the fourth signal wherein the third signal and fourth signal are of the opposite polarity. Altogether, now there are four different signals. Signals need to be with opposite phases so that they can be added together. Before the pressure can be controlled with these signals, these need to be amplified.

A quad high impedance amplifier is used to amplify the third signal (WF_A), the first signal (WF_C), the second signal (WF_B) and the fourth signal (WF_D) and the amplified signals are, the amplified third signal (P1+), the amplified first signal (P2-), the amplified second signal (P1-) and the amplified fourth signal (P2+), respectively.

The abovementioned four amplified signals (P1+, P1-, P2+, P2-) can be used for an asymmetrical multi-chamber pump, where each of the two piezoelectric actuators want a positive (P1+, P2+) and a negative (P1-, P2-) input. Herein, the term "*an asymmetrical multi-chamber pump*" refers to pumps that consist of several chambers through which the fluid passes. Each chamber can have a different size, shape, or volume, leading to asymmetrical flow patterns which helps create a specific flow dynamic, which can be optimized for various applications. This design can enhance the efficiency of mixing, pumping, or separating fluids. Many asymmetrical multi-chamber pumps use piezoelectric elements or electromagnetic actuators to generate the necessary mechanical motion. These actuators can create vibrations or displacements that drive fluid movement through the chambers. The asymmetrical multi-chamber pumps are used to handle very small volumes of fluids with high precision and the asymmetrical design can be particularly useful for tasks such as mixing reagents, delivering drugs, or performing chemical reactions on a micro-scale.

The amplified first signal (P2-) and the amplified second signal (P1-) are two anti-phase sine waves ready to drive the two negative electrodes of the piezoelectric pumps. The amplified third signal (P1+) and the amplified fourth signal (P2+) are used to drive the positive electrode of the other actuator. The amplified second signal (P1-) and the amplified third signal (P1+) are negative and positive contacts of a first a piezoelectric element. Similarly, the amplified first signal (P2-) and the amplified fourth signal (P2+) are negative and positive contacts of a second piezoelectric element. P1 and P2 are designed to be anti-phase. Both waveforms are asymmetrically polarized.

The technical effect of the abovementioned integrated modular multi-tone piezoelectric element driver is that it provides a more efficiently stabilizable pressure by using analog waveforms and waveform amplitude control. The analog oscillators provide lower noise and smoother actuation in comparison to digital oscillators, which introduce highfrequency, indiscriminate noise. Furthermore, using analog signal, the lifetime of the integrated modular multi-tone piezoelectric elements are increased by reducing steep changes in driving signal intensity. The integrated modular multi-tone piezoelectric element driver is compatible with multi chamber pumps. The modular structure of the integrated modular multi-tone piezoelectric element drivers allows to stack the first layer and the second layer, making it more compact and also modular, allowing to swap out the layers if necessary. The integrated modular multi-tone piezoelectric element driver offers a higher degree of control over the waveform shape, its component amplitudes and frequencies. The integrated modular multi-tone piezoelectric element driver is compatible with series-connection piezoelectric pumps.

Optionally, the primary analog oscillator, the second analog oscillator, the first voltage-controlled amplifier, the first level shifter, the summer, the second voltage-controlled amplifier, the second level shifter, the third level shifter, the fourth level shifter, the high impedance amplifier and the quad high impedance amplifier can all be operational amplifiers.

Optionally, the primary analog oscillator and the secondary analog oscillator are Wien-Bridge oscillators.

Optionally, the integrated modular multi-tone piezoelectric element driver further comprises of a high voltage supply configured to supply high voltage to each of the amplified third signal (P1+), the amplified first signal (P2-), the amplified fourth signal (P1-) and the amplified third signal (P2+). The second layer requires a high voltage supply which provides stable voltage for the second layer. Output of the high voltage supply is up to 240V DC.

The integrated modular multi-tone piezoelectric element driver needs a high voltage supply for operating. The high voltage supply can be an external or optionally, the high voltage supply is configured as a third layer (L3) comprising of a boost converter, further comprising: an inductor, a diode, a smoothing capacitor, and an active switch.

Herein, the term "third layer" refers to driver layer that is a high voltage supply that can be directly integrated into the integrated modular multi-tone piezoelectric element driver. The third layer can be shared between multiple of first and the second layers which will reduce the cost of integrated modular multi-tone piezoelectric element driver. The third layer passes the high voltage to the second layer and also through the first layer onto the PCB. To generate voltages as high as and beyond 200 V, with the source voltage of 5 V, very fast and high current switching is required.

Further, optionally, the boost converter circuit comprises a voltage multiplier circuit to expand the active switch, the diode and the smoothing capacitor selection so that their voltage tolerance would be as high as possible, have high efficiency in the boost converter circuit and still fit into the compact design of the integrated modular multi-tone piezoelectric element driver.

The third layer can be easily connected to the already modular structure of the piezoelectric element driver comprising the first layer and the second layer, making it more compact and allowing to swap out the layers if necessary. The technical effect of the third layer is that the high voltage supply can be easily integrated into the integrated modular multi-tone piezoelectric element driver making it easy to use in different systems.

Optionally, the integrated modular multi-tone piezoelectric element further comprises an externally controlled multi-channel adjustable impedance device for each oscillator, configured to allow adjustment of at least one of selected from following: oscillation frequency, oscillation amplitude. The advantage of the externally controlled multi-channel adjustable impedance device is that they allow to control the oscillation frequency and the oscillation amplitude of the minor waveform and the major waveform. This enhances the accuracy of the multi-tone waveform and in the end allows a better control over the pressure.

Optionally, the integrated modular multi-tone piezoelectric element driver has a footprint of the first layer, the second layer and the third layer that is compatible with DIP18 to facilitate integration with existing systems. The footprint of the layers is not tied to functionality but for compatibility of the layers. Using a standard package like DIP18 ensures that the integrated modular multi-tone piezoelectric element driver can be easily replaced or interchanged with other components that have the same footprint. This makes it easier to find replacements and upgrades. DIP18 provides enough pins to accommodate complex functionality while keeping the footprint manageable.

Optionally, the integrated modular multi-tone piezoelectric element driver is compatible with driving up to at least one of selected from following: four unipolar piezoelectric elements, two bipolar piezoelectric elements. The amplified third signal (P1+), the amplified first signal (P2-), the amplified second signal (P1-) and the amplified fourth signal (P2+) provide four signals that can be used for if the piezoelectric pump has either four unipolar piezoelectric elements or two bipolar piezoelectric elements. The two bipolar piezoelectric elements refer to the multi-chamber pumps (MCPs) as described above. Controlling the pressure of the four unipolar piezoelectric elements involves coordinating the signals applied to each element. To maintain the controlled pressure, the signals applied to each of the four piezoelectric elements need to be synchronized in such a way that their mechanical responses add constructively. The phase difference between the signals determines how the individual mechanical responses combine. For maximum pressure, the signals should be in phase (0 degrees phase difference) so that all elements expand or contract simultaneously. Additionally, the signals can be used to individually control four unipolar or two bipolar single-chamber pumps.

Optionally, the integrated modular multi-tone piezoelectric element driver is compatible with driving at least one of selected from the following: asymmetrically polarized piezoelectric elements, symmetrically polarized piezoelectric element. The asymmetrically polarized elements are designed to respond differently depending on the direction of the applied electric field, making them suitable for applications requiring directional sensitivity or specific directional actuation. The symmetrically polarized elements respond similarly regardless of the direction of the applied electric field, providing uniform actuation and are ideal for applications requiring consistent performance in multiple directions. The technical benefit of having the integrated modular multi-tone piezoelectric element driver compatible with both asymmetrically and symmetrically polarized piezoelectric elements lies in its versatility, flexibility, cost efficiency, enhanced performance, and simplified maintenance. This adaptability makes it a valuable component in diverse applications, from industrial automation to medical devices and beyond.

Optionally, the integrated modular multi-tone piezoelectric element driver wherein the one or more high impedance amplifiers are further configured as buffers to decouple the primary analog oscillator and the secondary analog oscillator from following current loads. The technical effect is that this enhances signal integrity, stability, reliability, and overall system performance. It also simplifies design and troubleshooting, making it a crucial consideration in high-performance and precision piezoelectric pumps. The term "*buffers*" herein refers to method where the input signal is replicated, and it provides stability for the signal.

Optionally, the integrated modular multi-tone piezoelectric element driver, wherein the one or more high impedance amplifiers are configured to buffer the direct current bias voltage source for the oscillators, level shifter and the summer. On the first layer, it is of importance that the major waveform and the adjusted minor waveform have a closely matching DC component to merge symmetrically around that voltage level, so that the minor oscillations added on top of the major oscillations would be balanced. The primary analog oscillator and the secondary analog oscillator, and the summer (with the exception of the first level shifter), apply a load on the bias voltage. In a passive, unbuffered configuration, the output voltage of a voltage divider circuit would deviate from the expected value depending on the load current - which is dependent on the waveform, thus oscillating and changing constantly. Buffering ensures that the voltage divider's output is not affected by the load, allowing to obtain a more reliable and accurate multi-tone waveform.

Optionally, the integrated modular multi-tone piezoelectric element driver further comprising an external waveform interface configured to allow at least one of selected from following: customization of the piezoelectric element-driving waveform, independence from the first layer. The term "external waveform interface" refers to an analog switch and an interface pin that leads up to it through the first layer to the second. If the integrated modular multi-tone piezoelectric element driver layers are in a stacked arrangement, it is guaranteed that the multi-tone waveform from the first layer is provided to the second layer. The analog switch intercepts it, allowing it to be replaced by the users own waveform provided through the interface pin. The effect of such customization is flexibility, that if needed (when in stacked arrangement), the user can also use digital oscillators or triple analog oscillators, or any signal that remains within the same voltage limits as the oscillations from the first layer (0 - 3.3 V). Another benefit is that, at this point in the second layer, to generate 4 output signals (forming P1 and P2), the user needs to supply but 1 waveform. The stacked arrangement of the driver provides an additional benefit, by enabling the user to choose if and when to use the signal from the first layer or their custom signal by "grounding" the interface pin or "supplying" their custom signal, respectively. If the interface pin is grounded, the analog switch will select to the multi-tone waveform from layer one as its output (accompanied by a delay). Independence from the first layer allows to omit the first layer entirely. In that case, it is possible to use both the interface pin and the pin that receives the multi-tone waveform from the first layer as inputs for the user's own waveform(s).

The present disclosure also relates to the second aspect as described above. Various embodiments and variants disclosed above, with respect to the aforementioned first aspect, apply *mutatis mutandis* to the second aspect.

A method of driving modular multi-tone piezoelectric element driver for pressure generation, the method comprising:
- generating a major waveform (WF1) with a primary analog oscillator;
- generating a minor waveform (WF2) with a secondary analog oscillator;
- adjusting an amplitude of the minor waveform with a first voltage-controlled amplifier to obtain an adjusted minor waveform (WF2*);
- correcting a direct current component of the adjusted minor waveform (WF2*);
- summing the major waveform and the adjusted minor waveform to create a multi-tone-waveform (WF1+WF2*);
- adjusting an amplitude of the multi-tone waveform (WF1+WF2*) to form an adjusted multi-tone waveform (WFx*);
- correcting the direct current component of the adjusted multi-tone waveform (WFx*);
- attenuating and subsequently inverting the adjusted multi-tone waveform (WFx*) to create an attenuated and inverted adjusted multi-tone waveform (WFxA) and inverting the attenuated and inverted adjusted multi-tone waveform (WFxA) to create an inverted waveform (-WFxA);
- adjusting the direct current level of the attenuated and inverted adjusted multi-tone waveform (WFxA) and the inverted waveform (-WFxA), resulting in a first signal (WF_C) and a second signal (WF_B), respectively;
- amplifying the first signal (WF_C) into a third signal (WF_A) and the second signal (WF_B) into a fourth signal (WF_D), respectively;
- amplifying the third signal (WF_A), the first signal (WF_C), the second signal (WF_B) and the fourth signal (WF_D) to respectively produce an amplified third signal (P1+), an amplified first signal (P2-), an amplified second signal (P1-) and an amplified fourth signal (P2+), wherein the amplified third signal (P1+), the amplified first signal (P2-), the amplified second signal (P1-) and the amplified fourth signal (P2+) used for pressure control.

The technical effect of the abovementioned method of driving modular multi-tone piezoelectric element driver for pressure generation is that it provides a method to more efficiently stabilizable pressure by using analog waveforms and waveform amplitude control. The minor waveform and the major waveform provided by the analog oscillators have lower noise and smoother actuation. Optionally, the frequency for the major waveform may be from 10, 250, 500, 750, 1000, 1250, 1500, 1750, 2000, 2250 Hz up to 100, 300, 550, 800, 1050, 1300, 1550, 1800, 2250, 2500 Hz. Optionally, the frequency for the minor waveform may be from 100, 1000, 2500, 5000, 7500, 10000, 12500, 15000, 17500, 20000, 22500 Hz up to 250, 1250, 3000, 5500, 8000, 10500, 13000, 15500, 18000, 20500, 25000 Hz. Wide range of the frequencies of the primary waveform and the major waveform provide allow to control the pressure of various liquids with different properties such as viscosity. The minor waveform causes proportionally less impactful movement in the piezoelectric pump compared to the major waveform, but it is the minor waveform that provides pulsations in pressure which can be controlled with less regard to its resonance with the pumped media. Instead, the minor waveform enables resonance to other components or particles in the piezoelectric pump or following pressurized system. Only the amplitude of the minor waveform is attenuated to play a less significant role in the driver output.

Correcting a direct current component of the adjusted minor waveform helps to maintain signal integrity, protect instruments where the integrated modular multi-tone piezoelectric element driver is used, ensure accurate signal processing, and achieving efficient and reliable operation of electronic systems.

Summing the major waveform and the adjusted minor waveform to create a multi-tone-waveform which provides more precise control over the piezoelectric elements. By using the major waveform and the minor waveform with different frequencies, the piezoelectric pump can achieve more refined control of fluid flow rates and pressures. Different combinations of the minor waveform and the major waveform frequencies can be used to switch between various flow rates or pressure settings without needing complex mechanical adjustments.

Correcting the direct current component of the adjusted multi-tone waveform is needed for maintaining symmetry in oscillations in order to avoid asymmetry when inverting the waveform which can result in inefficient operation, reduced performance, and increased wear and tear on mechanical components. Furthermore, it reduces the noise.

Attenuating and subsequently inverting the adjusted multi-tone waveform to create an attenuated and inverted adjusted multi-tone waveform and inverting the attenuated and inverted adjusted multi-tone waveform create an inverted waveform assures that there are two waveforms, the attenuated and inverted adjusted multi-tone waveform and the inverted waveform, are now accurate and in the correct phase.

Adjusting the direct current level of the attenuated and inverted adjusted multi-tone waveform and the inverted waveform resulting in a first signal and a second signal respectively is again needed for maintaining symmetry in oscillations as this asymmetry can result in inefficient operation, reduced performance, and increased wear and tear on mechanical components. Furthermore, it reduces the noise.

Amplifying the first signal into a third signal and the second signal into a fourth signal, respectively to produce signals of opposite polarity. Signals need to be with opposite phases so that they can be added together.

Last step is amplifying the third signal, the first signal, the second signal and the fourth signal to respectively produce an amplified third signal, an amplified first signal, an amplified second signal and an amplified fourth signal, wherein the amplified third signal, the amplified first signal, the amplified second signal and the amplified fourth signal used for pressure control.

These four amplified signals (P1+, P1-, P2+, P2-) can be used for an asymmetrical multi-chamber pump, where each of the two piezoelectric actuators want a positive (P1+, P2+) and a negative (P1-, P2-) input. Each chamber can have a different size, shape, or volume, leading to asymmetrical flow patterns which helps create a specific flow dynamic, which can be optimized for various applications. This method can enhance the efficiency of mixing, pumping, or separating fluids. The amplified first signal (P2-) and the amplified second signal (P1-) are two anti-phase sine waves ready to drive the two negative electrodes of the piezoelectric pumps. The amplified third signal (P1+) and the amplified fourth signal (P2+) are used to drive the positive electrode of the other actuator. The amplified second signal (P1-) and the amplified third signal (P1+) are negative and positive contacts of a first a piezoelectric element. Similarly, the amplified first signal (P2-) and the amplified fourth signal (P2+) are negative and positive contacts of a second piezoelectric element. P1 and P2 are designed to be anti-phase. Both waveforms are asymmetrically polarized.

### EXAMPLES

**Example 1.** Exemplary use of integrated modular multi-tone piezoelectric element driver for pressure generation.

The exemplary integrated modular multi-tone piezoelectric element driver has the first layer, the second layer and the third layer. All 3 layers are stacked on top of each other and inserted into a DIP18 socket on a piezo pump control/driver PCB. On the PCB, there is also an ESP32 development board that is connected to the driver. The ESP32 provides a PWM signal to the third layer, I2C commands to the digital potentiometers on the first layer and indirectly the voltage levels for the two separate VCA circuits on the first layer and the second layer. The VCA control voltage is provided by digital-to-analog converters (DAC) that are situated between the ESP32 and the driver on the PCB. The ESP32 communicates with the DACs using SPI. The ESP32 reads the downscaled high voltage output from the driver's third layer through the provided feedback pin. The ESP32 also has a connection with a pressure sensor that reads the pressure produced by the piezoelectric micropump that is driven by the piezo driver on the PCB. The pressure sensor provides feedback to a PID control-loop in the ESP32 that works to settle the "amplitude" of the piezo driver's P1 and P2 waveforms, that actuate the pump and produce a corresponding pressure level.

The primary analog oscillator and the secondary analog oscillator are two Wien-Bridge oscillators with independently selectable frequency using digital potentiometers. The oscillators produce sinewaves with positive polarity and with amplitudes up to the supply of 3.3 V (with balanced impedances on the non-inverting input, amplitude stabilizes at ~2.1 V). The voltage-controlled amplifiers are adjustable externally with a lowpass-filtered PWM or DAC between 0.35-2.45 V. To avoid clipping when adding the minor waveform to the major waveform, the minor waveform VCA ought to be adjusted between 0.35-1.45 V.

The second layer requires both 3.3 VDC and 5 VDC low voltage supplies. The additional 5 VDC is required to supply the low voltage side of a specific quad high impedance amplifier (HV264TS). The quad high impedance amplifier takes in four signals and amplifies them by about 67.7 times. The amplified signals will be known as P1-, P1+ (as piezo element 1 negative and positive contacts, respectively), P2- and P2+ (as piezo element 2 negative and positive contacts, respectively). P1 and P2 are designed to be anti-phase and unevenly polarized (negative side is 4x smaller than the positive side -> -50 V to 200 V, producing a maximum peak-to-peak voltage of 250 Vpp) by default to be used to control a dual-chamber piezo pump (mp6-liq, Bartels Mikrotechnik).

For the integrated modular multi-tone piezoelectric element driver to amplify the multi-tone waveform to voltages up to 250 Vpp, high-voltage operational amplifiers were used. To provide the supply voltage for these amplifiers, a boost converter was included on the driver. All three layers of the driver have a DIP18 footprint, making the layers stackable and additionally, the driver hot-swappable with Bartels' mp-Highdriver. Several of the DIP18 pins were dedicated for the boost converter control: DC input (5 V), switching signal (PWM), output feedback (0-3.0 V, auto disable at ~3.0 V corresponding to ~240 V boost converter output), DC input cut-off enable pin. The boost converter on the driver relied on an externally supplied PWM to have an adjustable high-voltage output to reduce losses when possible and to make the power supply noise frequency controllable.

### DETAILED DESCRIPTION OF THE DRAWINGS

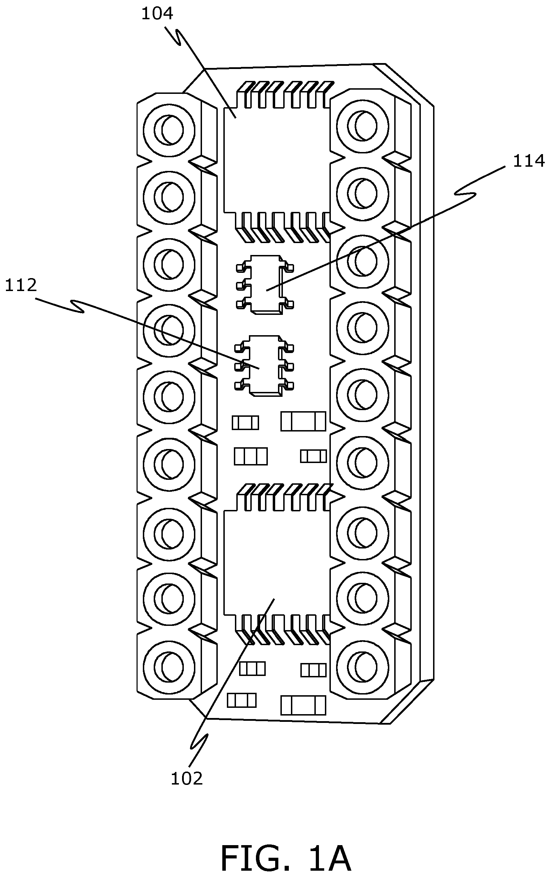

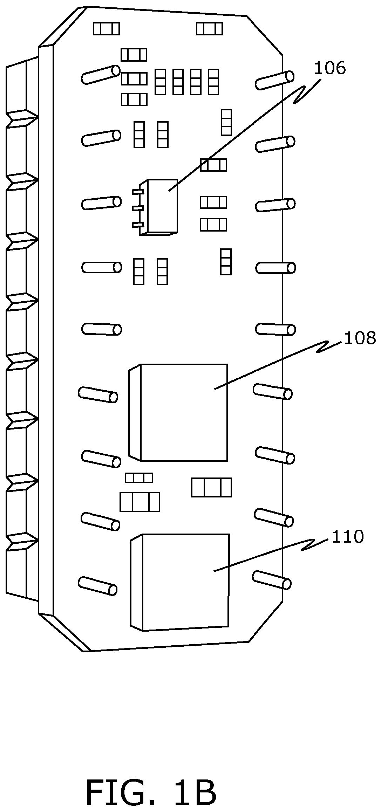

Referring to FIG. 1A and FIG. 1B, there is a schematic illustration of the first layer, where FIG. 1A represents a first side of the first layer and FIG. 1B represents a second side of the first layer. In FIG. 1A, the first side of the first layer comprises the oscillators **102,** the primary analog oscillator oscillator configured to generate a major waveform and the secondary analog oscillator configured to generate a minor waveform, the first level shifter configured to correct a direct current component of the adjusted minor waveform and the summer configured to sum the major waveform and the adjusted minor waveform to create a multi-tone waveform, indicated by **104,** in accordance with an embodiment of the present disclosure. In FIG. 1B, the second side of the first layer has the first voltage-controlled amplifier **106** configured to adjust the amplitude of the minor waveform to obtain an adjusted minor waveform, in accordance with an embodiment of the present disclosure. Additionally, the second side of the first layer has a first digital potentiometer **108** and a second digital potentiometer **110** for selecting frequencies for the primary analog oscillator and the secondary analog oscillator. Optionally, the first layer comprises a diode array **112** (shown in FIG. 1A), used for amplitude stabilization for the oscillators **102.** Additionally, optionally, the first layer comprises an inverter **114** (shown in FIG. 1A), to generate a second I2C for the second digital potentiometer.

It may be understood by a person skilled in the art that the FIG. 1A and FIG. 1B includes a simplified architecture of a first layer for sake of clarity, which should not unduly limit the scope of the claims herein. The person skilled in the art will recognize many variations, alternatives, and modifications of embodiments of the present disclosure.

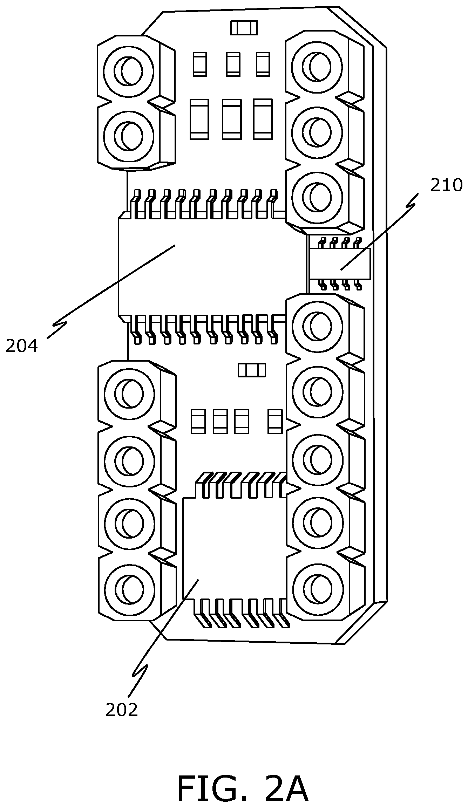

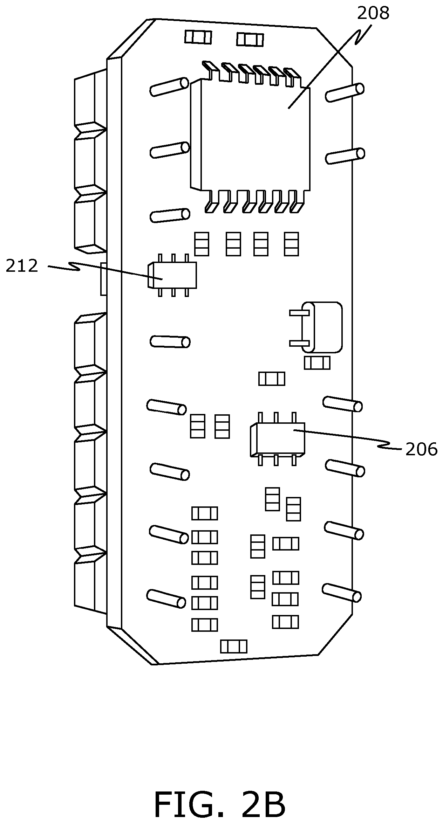

Referring to FIG. 2A and FIG. 2B, there is a schematic illustration of the second layer, where FIG 2A. represents a first side of the second layer and FIG. 2B represents a second side of the second layer. In FIG. 2A, the first side of the second layer comprises a second level shifter configured to correct the direct current component of the adjusted multi-tone waveform and one or more operational amplifiers configured to attenuate and subsequently invert the adjusted multi-tone waveform to create an attenuated and inverted adjusted multi-tone waveform and to invert the attenuated and inverted adjusted multi-tone waveform to create an inverted waveform which are both located in **202,** in accordance with an embodiment of the present disclosure. The first side of the second layer also locates a quad high impedance amplifier in **204** configured to amplify the third signal, the first signal, the second signal and the fourth signal to respectively produce an amplified third signal, an amplified first signal, an amplified second signal and an amplified fourth signal, wherein the amplified third signal, the amplified first signal, the amplified second signal and the amplified fourth signal are used for controlling a pressure, in accordance with an embodiment of the present disclosure. Optionally, the second layer comprises a comparator **210** to detect a presence of a custom waveform (shown in FIG. 2A).

In FIG. 2B, the second side of the second layer comprises a second voltage-controlled amplifier **206** configured to adjust an amplitude of the multi-tone waveform to obtain an adjusted multi-tone waveform, in accordance with an embodiment of the present disclosure. A third level shifter and a fourth level shifter are located on the same side in **208** and are configured to adjust the direct current level of the attenuated and inverted adjusted multi-tone waveform and the inverted waveform, resulting in a first signal and a second signal, respectively, in accordance with an embodiment of the present disclosure. Additionally, one or more high impedance amplifiers are also located in **208** and are configured to amplify the first signal into a third signal and the second signal into a fourth signal, respectively. Optionally, the second layer comprises the external waveform interface **212** which refers to an analog switch and an interface pin that leads up to it through the first layer to the second and is configured to allow at least one of selected from following: customization of the piezoelectric element-driving waveform, independence from the first layer.

It may be understood by a person skilled in the art that the FIG. 2A and FIG. 2B includes a simplified architecture of a second layer for sake of clarity, which should not unduly limit the scope of the claims herein. The person skilled in the art will recognize many variations, alternatives, and modifications of embodiments of the present disclosure.

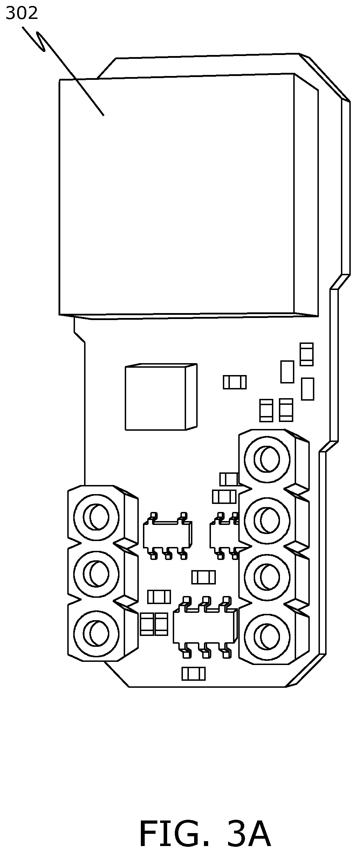

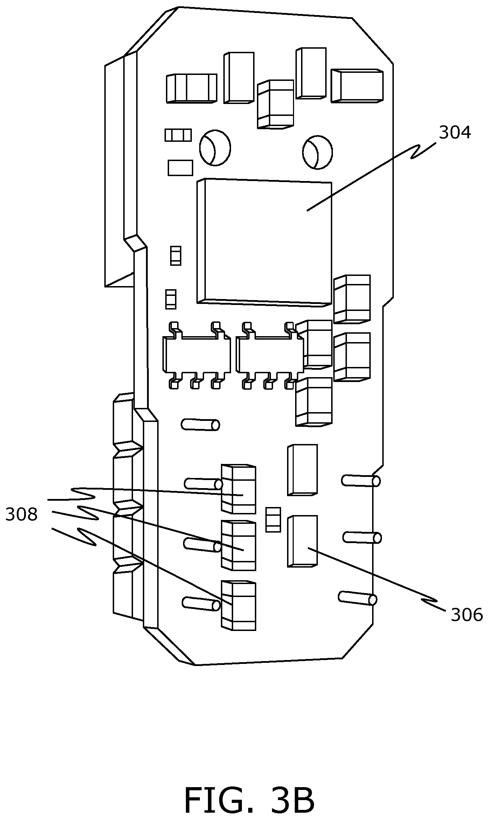

Referring to FIG. 3A and FIG. 3B, there is a schematic illustration of the third layer, where FIG 3A. represents a first side of the third layer and FIG. 3B represents a second side of the third layer. A boost converter in shown on both FIG. 3A and FIG. 3B, wherein a inductor **302** is on the first side of the third layer and an active swich **304** is the second side of the third layer. The third layer also comprises a diode **306** and a smoothing capacitor **308,** optionally, in FIG. 3B shown are three smoothing capacitors.

It may be understood by a person skilled in the art that the FIG. 3A and FIG. 3B includes a simplified architecture of a third layer for sake of clarity, which should not unduly limit the scope of the claims herein. The person skilled in the art will recognize many variations, alternatives, and modifications of embodiments of the present disclosure.

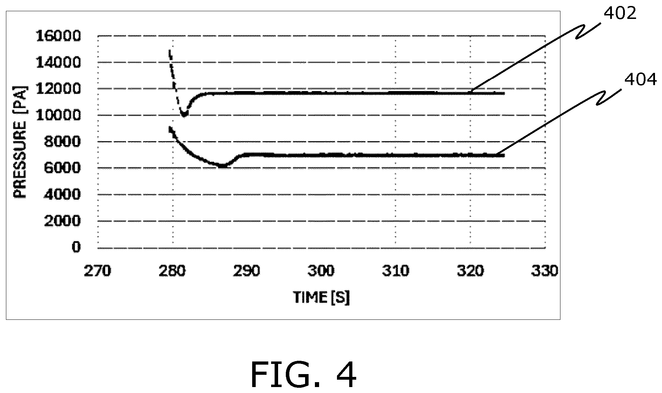

Referring to FIG. 4, there is a graph illustrating a generated pressure with the integrated modular multi-tone piezoelectric element driver. The integrated modular multi-tone piezoelectric element driver was used to generate pressure (y-axis) for water and oil during a 30 second time period (x-axis). **402** shows a measured oil pressure and **404** a measured water pressure.

It may be understood by a person skilled in the art that the FIG. 4 includes one example of the generated pressures, which should not unduly limit the scope of the claims herein. The person skilled in the art will recognize many variations, alternatives, and modifications of embodiments of the present disclosure.

## Claims

1. An integrated modular multi-tone piezoelectric element driver for pressure generation, comprising:
a first layer (L1) comprising:
- a primary analog oscillator configured to generate a major waveform (WF1),
- a secondary analog oscillator configured to generate a minor waveform (WF2),
- a first voltage-controlled amplifier configured to adjust the amplitude of the minor (WF2) waveform to obtain an adjusted minor waveform (WF2*)
- a first level shifter configured to correct a direct current component of the adjusted minor waveform (WF2*),
- a summer configured to sum the major waveform (WF1) and the adjusted minor waveform (WF2*) to create a multi-tone waveform (WFx),
a second layer (L2) comprising:
- a second voltage-controlled amplifier configured to adjust an amplitude of the multi-tone waveform (WFx) to obtain an adjusted multi-tone waveform (WFx*),
- a second level shifter configured to correct the direct current component of the adjusted multi-tone waveform (WFx*),
- one or more operational amplifiers configured to attenuate and subsequently invert the adjusted multi-tone waveform (WFx*) to create an attenuated and inverted adjusted multi-tone waveform (WFxA) and to invert the attenuated and inverted adjusted multi-tone waveform (WFxA) to create an inverted waveform (-WFxA),
- a third level shifter and a fourth level shifter configured to adjust the direct current level of the attenuated and inverted adjusted multi-tone waveform (WFxA) and the inverted waveform (-WFxA), resulting in a first signal (WF_C) and a second signal (WF_B), respectively,
- one or more high impedance amplifiers configured to amplify the first signal (WF_C) into a third signal (WF_A) and the second signal (WF_B) into a fourth signal (WF_D), respectively,
- a quad high impedance amplifier configured to amplify the third signal (WF_A), the first signal (WF_C), the second signal (WF_B) and the fourth signal (WF_D) to respectively produce an amplified third signal (P1+), an amplified first signal (P2-), an amplified second signal (P1-) and an amplified fourth signal (P2+), wherein the amplified third signal (P1+), the amplified first signal (P2-), the amplified second signal (P1-) and the amplified fourth signal (P2+) are used for controlling a pressure.

2. The integrated modular multi-tone piezoelectric element driver according to claim 1, further comprising of a high voltage supply configured to supply high voltage to each of the amplified third signal (P1+), the amplified first signal (P2-), the amplified fourth signal (P1-) and the amplified third signal (P2+).

3. The integrated modular multi-tone piezoelectric element driver according to claim 2, wherein the high voltage supply is configured as a third layer (L3) comprising a boost converter, further comprising:
an inductor,
a diode,
a smoothing capacitor, and
an active switch.

4. An integrated modular multi-tone piezoelectric element driver according to any of the preceding claims, further comprising of an externally controlled multi-channel adjustable impedance device for each oscillator, configured to allow adjustment of at least one of selected from following: oscillation frequency, oscillation amplitude.

5. The integrated modular multi-tone piezoelectric element driver according to any of the preceding claims, wherein a footprint of the first layer, the second layer and the third layer is compatible with DIP18 to facilitate integration with existing systems.

6. The integrated modular multi-tone piezoelectric element driver according to any of the preceding claims, wherein the integrated modular multi-tone piezoelectric element driver is compatible with driving up to at least one of selected from following: four unipolar piezoelectric elements, two bipolar piezoelectric elements.

7. The integrated modular multi-tone piezoelectric element driver according to any of the preceding claims, wherein the integrated modular multi-tone piezoelectric element driver is compatible with driving at least one of selected from the following: asymmetrically polarized piezoelectric elements, symmetrically polarized piezoelectric elements.

8. The integrated modular multi-tone piezoelectric element driver according to any of the preceding claims, wherein the one or more high impedance amplifiers are further configured as buffers to decouple the primary analog oscillator and the secondary analog oscillator from following current loads.

9. The integrated modular multi-tone piezoelectric element driver according to any of the preceding claims, wherein the one or more high impedance amplifiers are configured to buffer the direct current bias voltage source for the oscillators, level shifter and the summer.

10. The integrated modular multi-tone piezoelectric element driver according to any of the preceding claims, further comprising an external waveform interface configured to allow at least one of selected from following: customization of the piezoelectric element-driving waveform, independence from the first layer (L1).

11. A method of driving modular multi-tone piezoelectric element driver for pressure generation, the method comprising:
- generating a major waveform (WF1) with a primary analog oscillator;
- generating a minor waveform (WF2) with a secondary analog oscillator;
- adjusting an amplitude of the minor waveform with a first voltage-controlled amplifier to obtain an adjusted minor waveform (WF2*);
- correcting a direct current component of the adjusted minor waveform (WF2*);
- summing the major waveform and the adjusted minor waveform to create a multi-tone-waveform (WF1+WF2*);
- adjusting an amplitude of the multi-tone waveform (WF1+WF2*) to form an adjusted multi-tone waveform (WFx*);
- correcting the direct current component of the adjusted multi-tone waveform (WFx*);
- attenuating and subsequently inverting the adjusted multi-tone waveform (WFx*) to create an attenuated and inverted adjusted multi-tone waveform (WFxA) and inverting the attenuated and inverted adjusted multi-tone waveform (WFxA) to create an inverted waveform (-WFxA);
- adjusting the direct current level of the attenuated and inverted adjusted multi-tone waveform (WFxA) and the inverted waveform (-WFxA), resulting in a first signal (WF_C) and a second signal (WF_B), respectively;
- amplifying the first signal (WF_C) into a third signal (WF_A) and the second signal (WF_B) into a fourth signal (WF_D), respectively;
- amplifying the third signal (WF_A), the first signal (WF_C), the second signal (WF_B) and the fourth signal (WF_D) to respectively produce an amplified third signal (P1+), an amplified first signal (P2-), an amplified second signal (P1-) and an amplified fourth signal (P2+), wherein the amplified third signal (P1+), the amplified first signal (P2-), the amplified second signal (P1-) and the amplified fourth signal (P2+) used for pressure control.
